# EUROPEAN PATENT APPLICATION

(11) **EP 4 056 660 A1**
(43) Date of publication of application: **14.09.2022**
(21) Application number: 22160233.7
(22) Date of filing: 04.03.2022
(51) Int. Cl.: C09J 7/10, C09J 7/38, C09J 133/00

(54) **OPTICAL PRESSURE-SENSITIVE ADHESIVE COMPOSITION**

(30) Priority: 08.03.2021 JP 2021036210
(71) Applicant: NITTO DENKO CORPORATION, Ibaraki-shi Osaka 567-8680 (JP)
(72) Inventor: Yamamoto, Shinya, Ibaraki-shi, Osaka (JP); Takarada, Sho, Ibaraki-shi, Osaka (JP); Kosaka, Naofumi, Ibaraki-shi, Osaka (JP); Nonaka, Takahiro, Ibaraki-shi, Osaka (JP)
(74) Representative: Grünecker Patent- und Rechtsanwälte PartG mbB

(57) **Abstract**

Provided is an optical pressure-sensitive adhesive composition that gives a pressure-sensitive adhesive layer having such heating reworkability as to be easily removed from a component such as cover glass at a temperature higher than the service temperature of an image display device. The optical pressure-sensitive adhesive composition of the present invention gives a release force X of 4.0 N/20 mm or less, where the release force X is a release force determined by applying a film to a glass plate through a pressure-sensitive adhesive layer made from the optical pressure-sensitive adhesive composition, and puling the film at a temperature of 100°C, a peel angle of 180 degrees, and a tensile speed of 50 mm/min.

## Description

### Technical Field

The present invention relates to optical pressure-sensitive adhesive compositions (pressure-sensitive adhesive compositions for optical use).

### Background Art

In an image display panel, space between the image display panel and another component such as cover glass or film sensor is packed with a pressure-sensitive adhesive layer, so as to restrain the image display panel from reduction in visibility caused by light refraction or reflection, and/or to restrain or augment strength poverty due to fixation of the housing alone. For example, Patent Literature (PTL) 1, which is technical literature relating to such pressure-sensitive adhesives for the above use, discloses an optical pressure-sensitive adhesive.

When an image display device bears a foreign substance (such as microgel) in the pressure-sensitive adhesive layer and is evaluated as a defective piece, the component such as the cover glass is separated, and the residual non-defective image display panel is recovered and reused. The component such as cover glass is separated typically by a process of sliding a metal wire into the pressure-sensitive adhesive layer to cut off the pressure-sensitive adhesive layer from the image display panel.

### Citation List

### Patent Literature

PTL 1 Japanese Unexamined Patent Application Publication (JP-A) No. 2020-023679

### Summary of Invention

### Technical Problem

Using organic electroluminescent display panels, demands for image display devices (e.g., car-mounted displays such as car navigation systems and back monitors) that are designed, for example, to have a larger size, to have a curved surface, to include multi-displays, or to have a modified (complicated) shape more and more increase. With this, a component such as cover glass is also designed to have a larger size and/or a complicated shape and becomes very expensive. This strongly demands that the component such as cover glass can also be recovered and reused when the image display device is evaluated as a defective piece.

However, it is difficult to separate such a large-sized, complicated-shaped component, such as cover glass, without damage from the organic electroluminescent display panel typically by the above-mentioned process of sliding a metal wire to separate the pressure-sensitive adhesive layer.

In contrast to a liquid crystal display panel formed on a glass substrate, an organic electroluminescent display panel formed on a polyimide substrate is flexible. This allows the component such as cover glass to be removed from the pressure-sensitive adhesive layer without cutting off the pressure-sensitive adhesive layer. Specifically, the pressure-sensitive adhesive layer is heated to a high temperature higher than the service temperature to lower the bond strength of the pressure-sensitive adhesive layer to the component such as cover glass, and then bent together with the organic electroluminescent display panel, to separate from the component.

To eliminate or minimize damage and deformation of the image display panel and the component such as cover glass during separation and recovery, the bond strength (release force) required upon removal is to be kept low. However, it is not easy to achieve such a low release force while providing high bonding reliability upon use of the image display device.

The present invention has been made under these circumstances and has an object to provide an optical pressure-sensitive adhesive composition that provides such heating reworkability that a pressure-sensitive adhesive layer made from the composition can be easily removed from a component such as cover glass at a temperature higher than the service temperature of an image display device. Solution to Problem

After intensive investigations to achieve the object, the inventors of the present invention have found that an optical pressure-sensitive adhesive composition giving specific release forces can provide good heating reworkability upon use. The present invention has been made on the basis of these findings.

Specifically, the present invention provides an optical pressure-sensitive adhesive composition giving a release force X of 4.0 N/20 mm or less, where the release force X is a release force determined by applying a film to a glass plate through a pressure-sensitive adhesive layer made from the optical pressure-sensitive adhesive composition, and pulling the film at a temperature of 100°C, a peel angle of 180 degrees, and a tensile speed of 50 mm/min.

The optical pressure-sensitive adhesive composition preferably gives a ratio (Y/X) of a release force Y to the release force X of 15.0 or less, where the release force Y is a release force determined by applying a film to a glass plate through a pressure-sensitive adhesive layer made from the optical pressure-sensitive adhesive composition, and pulling the film at a temperature of 25°C, a peel angle of 180 degrees, and a tensile speed of 50 mm/min.

The optical pressure-sensitive adhesive composition preferably has a storage modulus at 100°C of 0.1 ×10⁵ Pa or greater.

The optical pressure-sensitive adhesive composition preferably has a moisture content of 0.6 to 5.0 weight percent when stored at a temperature of 23°C and relative humidity of 50% for 24 hours.

The optical pressure-sensitive adhesive composition preferably gives a variation in chromaticity b* of 1.0 or less, where the variation is a variation in chromaticity b* of a pressure-sensitive adhesive layer made from the optical pressure-sensitive adhesive composition and is determined when the pressure-sensitive adhesive layer is placed between a pair of glass plates and is then stored at 100°C for 1000 hours.

The present invention also provides a pressure-sensitive adhesive layer made from the optical pressure-sensitive adhesive composition.

The pressure-sensitive adhesive layer is preferably to be applied to at least one of a film substrate and an organic electroluminescent display panel as an adherend. Advantageous Effects of Invention

The optical pressure-sensitive adhesive composition of the present invention has the configurations and thereby provides such excellent heating reworkability of the resulting pressure-sensitive adhesive layer as to be easily removed from the component such as cover glass at a high temperature. The use of the optical pressure-sensitive adhesive composition of the present invention therefore allows the large-sized and/or complicated-shaped component such as cover glass and the organic electroluminescent display panel to separate from each other without damage and deformation.

### Brief Description of Drawings

FIG. 1 is a schematic cross-sectional view of an image display device; and
FIG. 2 is a schematic cross-sectional view of the image display device upon separation and recovery.

### Description of Embodiments

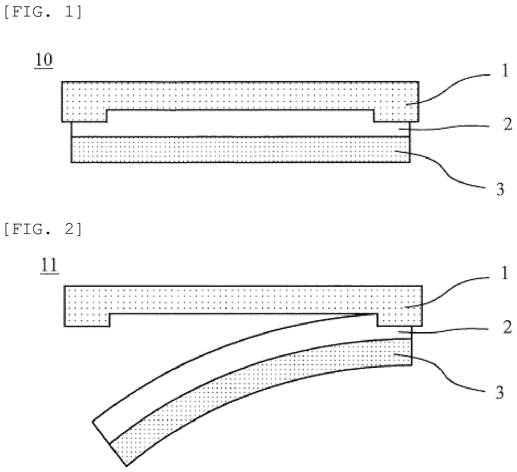

FIG. 1 is a schematic cross-sectional view of an image display device 10. The image display device 10 has a pressure-sensitive adhesive layer 2 made from an optical pressure-sensitive adhesive composition of the present invention. The pressure-sensitive adhesive layer 2 is disposed between a cover glass 1 and an organic electroluminescent display panel 3 and bonds these components.

FIG. 2 is a schematic cross-sectional view of an image display device 11 upon separation and recovery. The organic electroluminescent display panel 3 is flexible and can bend together with the pressure-sensitive adhesive layer 2. This allows the pressure-sensitive adhesive layer 2 to be easily removed from the cover glass 1 with bending, by decreasing the bond strength at a temperature higher than that in use of the image display device (service temperature).

### Optical Pressure-Sensitive Adhesive Composition

The optical pressure-sensitive adhesive composition (pressure-sensitive adhesive composition for optical use) of the present invention gives a release force X of 4.0 N/20 mm or less, where the release force X is a release force determined by applying a film to a glass plate through the medium of a pressure-sensitive adhesive layer made from the optical pressure-sensitive adhesive composition, and pulling the film at a temperature of 100°C, a peel angle of 180 degrees, and a tensile speed of 50 mm/min.

The configuration of the optical pressure-sensitive adhesive composition of the present invention as giving a release force X of 4.0 N/20 mm or less is advantageous in that the pressure-sensitive adhesive layer made from or derived from the optical pressure-sensitive adhesive composition can have such excellent heating reworkability as to be easily removed from the glass upon separation and recovery.

The release force X is preferably, but non-limitingly, 3.6 N/20 mm or less, and more preferably 3.3 N/20 mm or less. The lower limit of the release force X is not limited, but is generally 0.5 N/20 mm, or may be 1.0 N/20 mm, or 1.5 N/20 mm. The optical pressure-sensitive adhesive composition, when giving a release force X of 0.5 N/20 mm or greater, contributes to better reworkability at a high temperature.

The temperature at which separation of the pressure-sensitive adhesive layer from the component such as cover glass is performed is not limited, but is preferably about 100°C. This is preferred in view that the organic electroluminescent display panel more tends to deteriorate when exposed to an excessively high temperature upon separation and recovery, while the device such as an in-vehicle display may be exposed to a high temperature of about 80°C in summer, and thus the pressure-sensitive adhesive layer is required to have durability at a temperature higher than 80°C. The temperature condition of 100°C in the determination of the release force X is established in view of these.

The optical pressure-sensitive adhesive composition of the present invention preferably gives a ratio (Y/X) of a release force Y to the release force X of 15.0 or less, where the release force Y is a release force determined by applying a film to a glass plate through a pressure-sensitive adhesive layer made from the optical pressure-sensitive adhesive composition, and pulling the film at a temperature of 25°C, a peel angle of 180 degrees, and a tensile speed of 50 mm/min.

The configuration of the optical pressure-sensitive adhesive composition of the present invention as giving a ratio (Y/X) of 15.0 or less is advantageous in that the pressure-sensitive adhesive layer made from the optical pressure-sensitive adhesive composition features compatibility between heating reworkability and durability.

The ratio (Y/X) is more preferably, but non-limitingly, 13.0 or less, and still more preferably 11.0 or less. The lower limit of the ratio (Y/X) is not limited, but may typically be 1.0, or may be 1.5 or 2.0. When the ratio (Y/X) is 1.0 or greater, the pressure-sensitive adhesive layer can surely have heating reworkability while having sufficient durability under reliability test conditions.

The release force Y is not limited, but is preferably 20.0 N/20 mm or less, more preferably 18.0 N/20 mm or less, and still more preferably 16.0 N/20 mm or less. The lower limit of the release force Y is not limited, but may typically be 2.0 N/20 mm, or may be 3.0 N/20 mm or 4.0 N/20 mm. The pressure-sensitive adhesive composition, when giving a release force Y of 20.0 N/20 mm or less, effectively contributes to better reworkability, and, when giving a release force Y of 2.0 N/20 mm or greater, allows the pressure-sensitive adhesive layer to resist separation under reliability test conditions.

The release forces (release force X, ratio (Y/X), and release force Y) can be set within the preferred ranges, by appropriately adjusting, for example in the acrylic polymer of the after-mentioned acrylic pressure-sensitive adhesive composition, the content of units derived from the after-mentioned polar-group-containing monomer (such as a hydroxy-containing monomer and a nitrogen-containing-group-containing monomer), and thereby controlling the adhesive strength and/or the degree of moisture release upon separation and recovery.

The optical pressure-sensitive adhesive composition of the present invention preferably has a storage modulus at 100°C (G'100) of 0.1 ×10⁵ Pa or greater.

The configuration of the optical pressure-sensitive adhesive composition of the present invention as having a storage modulus (G'100) of 0.1 ×10⁵ Pa or greater is advantageous in that the pressure-sensitive adhesive layer made from the optical pressure-sensitive adhesive composition less remains as adhesive residue on the glass upon separation and recovery.

The storage modulus (G'100) is not limited, but is more preferably 0.2 ×10⁵ Pa or greater, and still more preferably 0.3 ×10⁵ Pa or greater. The upper limit of the storage modulus (G'100) may typically be 2.5 ×10⁵ Pa, or may be 2.0 ×10⁵ Pa or 1.5 ×10⁵ Pa. The pressure-sensitive adhesive composition, when having a storage modulus (G'100) of 2.5 ×10⁵ Pa or less, is more flexible and is more easy-to-handle during rework at a high temperature.

The optical pressure-sensitive adhesive composition has a storage modulus at 25°C (G'25) of preferably 1.0 ×10⁵ Pa or greater, more preferably 1.3 ×10⁵ Pa or greater, and still more preferably 1.5 ×10⁵ Pa or greater, although the composition may have any other storage modulus at 25°C. The upper limit of the storage modulus (G'25) may typically be 4.0 ×10⁵ Pa, or may be 3.5 ×10⁵ Pa or 3.0 ×10⁵ Pa. The pressure-sensitive adhesive composition, when having a storage modulus (G'25) of 1.0 ×10⁵ Pa or greater, has better handleability; and, when having a storage modulus (G'25) of 4.0 ×10⁵ Pa or less, tends to have better conformability to bumps (bump absorptivity) upon use.

The storage moduli can be determined typically by dynamic viscoelastic measurement using a dynamic viscoelastometer (Advanced Rheometric Expansion System (ARES), Rheometric Scientific).

The storage moduli can be set within the preferred ranges by appropriately controlling, for example in the acrylic polymer in the acrylic pressure-sensitive adhesive composition, the contents of units derived from the after-mentioned (meth)acrylic alkyl ester and the after-mentioned alicyclic monomer, the weight-average molecular weight, and the content of a crosslinker and/or a multifunctional monomer.

The optical pressure-sensitive adhesive composition of the present invention has a moisture content of preferably 0.6 to 5.0 weight percent, more preferably 0.7 to 3.5 weight percent, and still more preferably 0.8 to 2.0 weight percent, when stored at a temperature of 23°C and relative humidity of 50% for 24 hours. The optical pressure-sensitive adhesive composition, when having a moisture content as above of 0.6 weight percent or greater, more tends to have a lower release force due to release of moisture to the interface with the glass upon heating at a high temperature in separation and recovery; and, when having a moisture content of 5.0 weight percent or less, less causes dew condensation.

The moisture content can be determined typically by coulometric-titration moisture measurement using a coulometric titration moisture meter Model CA-06 (available from Mitsubishi Chemical Corporation (now Nittoseiko Analytech Co., Ltd.)) and a thermal vaporizer Model VA-06 (available from Mitsubishi Chemical Corporation (now Nittoseiko Analytech Co., Ltd.)), or by measuring weights before and after storage and subtracting the weight before storage from the weight after storage.

The moisture content can be set within the preferred range by appropriately adjusting, for example in the acrylic polymer in the acrylic pressure-sensitive adhesive composition, the content of units derived from the polar-group-containing monomer (such as a hydroxy-containing monomer and a nitrogen-containing-group-containing monomer).

The optical pressure-sensitive adhesive composition of the present invention gives a variation in chromaticity b* of preferably 1.0 or less, more preferably 0.8 or less, and still more preferably 0.7 or less, where the variation is a variation in chromaticity b* of a pressure-sensitive adhesive layer made from or formed from the optical pressure-sensitive adhesive composition and is determined by applying glass plates to both sides of the pressure-sensitive adhesive layer, storing the resulting article at 100°C for 1000 hours, and measuring the chromaticity b* before and after storage. The pressure-sensitive adhesive layer, when giving a variation in chromaticity b* of 1.0 or less, is advantageous in that the pressure-sensitive adhesive layer less changes in hue (color) even exposed to a high temperature upon separation and recovery, indicating that the pressure-sensitive adhesive layer has excellent durability. The lower limit of the variation in chromaticity b* is generally 0.

The variation in chromaticity b* can be determined typically by measuring chromaticity b* of the pressure-sensitive adhesive layer before and after storage using a spectrophotometer U-4100 available from Hitachi High-Tech Corporation, and subtracting the chromaticity b* before storage from the chromaticity b* after storage.

As is described above, the release forces, the storage moduli, and the moisture content can be adjusted by adjusting conditions or factors of the resin, such as resin type, monomer composition, and degree of crosslinking, constituting the optical pressure-sensitive adhesive composition.

The term "optical" in the optical pressure-sensitive adhesive composition refers to that the composition is used for optical use. More specifically, the term "optical" means that the composition is used typically for the production of an optical product, which is a product including or using an optical element. Non-limiting examples of the optical product include image display devices, and input devices such as touch screens (touch panels), of which light-emitting display devices, such as organic electroluminescent display devices, are preferred.

Non-limiting examples of the optical pressure-sensitive adhesive composition include acrylic pressure-sensitive adhesive compositions, rubber pressure-sensitive adhesive compositions, silicone pressure-sensitive adhesive compositions, polyester pressure-sensitive adhesive compositions, polyurethane pressure-sensitive adhesive compositions, polyamide pressure-sensitive adhesive compositions, epoxy pressure-sensitive adhesive compositions, vinyl alkyl ether pressure-sensitive adhesive compositions, and fluorocarbon pressure-sensitive adhesive compositions. The optical pressure-sensitive adhesive composition may include each of different pressure-sensitive adhesive compositions alone or in combination.

Particularly, the optical pressure-sensitive adhesive composition preferably includes an acrylic pressure-sensitive adhesive composition, because such an acrylic pressure-sensitive adhesive composition tends to have a lower release force upon separation and recovery while having excellent adhesion.

The acrylic pressure-sensitive adhesive composition preferably includes an acrylic polymer as a polymer component. As used herein the term "(meth)acrylic" refers to "acrylic" and/or "methacrylic" (one or both of "acrylic" and "methacrylic"), and the same is true for other expressions. For example, the term "(meth)acryloyl" refers to "acryloyl" and/or "methacryloyl" (one or both of "acryloyl" and "methacryloyl"). The acrylic polymer, when being a copolymer, may be a random copolymer or a block copolymer.

The acrylic polymer is preferably, for example, one including a unit derived from a (meth)acrylic alkyl ester having linear or branched alkyl containing 1 to 20 carbons at ester terminal, in a content of greater than 30 weight percent of the totality (100 weight percent) of all monomer units. Hereinafter a (meth)acrylic alkyl ester having alkyl containing m to 1 carbons at ester terminal is also referred to as a " (meth) acrylic Cₘ-Cₗ alkyl ester".

Specific, but non-limiting examples of the (meth) acrylic C₁-C₂₀ alkyl ester include methyl (meth)acrylate, ethyl (meth)acrylate, propyl (meth)acrylate, isopropyl (meth)acrylate, n-butyl (meth)acrylate, s-butyl (meth)acrylate, isobutyl (meth)acrylate, t-butyl (meth)acrylate, pentyl (meth)acrylate, isopentyl (meth)acrylate, hexyl (meth)acrylate, heptyl (meth)acrylate, octyl (meth)acrylate, 2-ethylhexyl (meth)acrylate, isooctyl (meth)acrylate, nonyl (meth)acrylate, isononyl (meth)acrylate, decyl (meth)acrylate, isodecyl (meth)acrylate, undecyl (meth)acrylate, dodecyl (meth)acrylate, tridecyl (meth)acrylate, tetradecyl (meth)acrylate, pentadecyl (meth)acrylate, hexadecyl (meth)acrylate, heptadecyl (meth)acrylate, octadecyl (meth)acrylate, isostearyl (meth)acrylate, nonadecyl (meth)acrylate, and icosyl (meth)acrylate. Among them, n-butyl acrylate, 2-ethylhexyl acrylate, and isostearyl acrylate are preferred.

The content of such a unit derived from the (meth) acrylic C₁-C₂₀ alkyl ester in the acrylic polymer is preferably greater than 30 weight percent, more preferably 35 weight percent or greater, still more preferably 40 weight percent or greater, and particularly preferably 45 weight percent or greater, of the totality (100 weight percent) of all the monomer units. The upper limit of the content may typically be 98 weight percent, or may be 90 weight percent, 70 weight percent, or 55 weight percent. The acrylic polymer, when containing the unit derived from the (meth) acrylic C₁-C₂₀ alkyl ester in a content within the range, can more easily balance between adhesive strength and cohesive force.

The acrylic polymer may include a monomer unit or units derived from each of different (meth) acrylic C₁-C₂₀ alkyl esters alone or in combination.

The acrylic polymer may include a unit derived from another monomer (copolymerizable monomer) having (meth)acryloyl or alkenyl and being polymerizable with the (meth)acrylic alkyl ester. Non-limiting examples of the copolymerizable monomer include polar-group-containing monomers each containing a polar group (such as carboxy, acid anhydride, hydroxy, sulfonic or phosphoric, epoxy, or nitrogen-containing group); and alicyclic monomers. The acrylic polymer may include a unit or units derived from each of different copolymerizable monomers alone or in combination.

Non-limiting examples of the carboxy-containing monomer include acrylic acid, methacrylic acid, carboxyethyl acrylate, carboxypentyl acrylate, itaconic acid, maleic acid, fumaric acid, crotonic acid, and isocrotonic acid.

Non-limiting examples of the acid anhydride-containing monomer include maleic anhydride and itaconic anhydride.

The total content of units derived from a carboxy-containing monomer and an acid anhydride-containing monomer in the acrylic polymer may be 1 weight percent or less, or may be 0.5 weight percent or less, of the totality (100 weight percent) of all the monomer units, for eliminating or minimizing metal corrosion. The lower limit of the total content is generally 0 weight percent, because such monomers are preferably not used at least intentionally.

Non-limiting examples of the hydroxy-containing monomer include hydroxyalkyl (meth)acrylates, such as 2-hydroxyethyl (meth)acrylate, 2-hydroxypropyl (meth)acrylate, 2-hydroxybutyl (meth)acrylate, 3-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, and (4-hydroxymethylcyclohexyl)methyl (meth)acrylate. Among them, 2-hydroxyethyl acrylate, 2-hydroxyethyl methacrylate, 2-hydroxypropyl acrylate, 2-hydroxypropyl methacrylate, 4-hydroxybutyl acrylate, and 4-hydroxybutyl methacrylate are preferred.

The acrylic polymer may contain a unit derived from the hydroxy-containing monomer in a content of preferably 1.0 weight percent or greater, more preferably 2.0 weight percent or greater, still more preferably 5 weight percent or greater, particularly preferably 10 weight percent or greater, and most preferably 15 weight percent or greater, of the totality (100 weight percent) of all the monomer units. The upper limit of the content may typically be 50 weight percent, or may be 45 weight percent, 40 weight percent, or 35 weight percent. The acrylic polymer, when including such a unit derived from the hydroxy-containing monomer in a content of 1.0 weight percent or greater, tends to enable appropriate control of the tackiness of the pressure-sensitive adhesive and the extent of crosslinking by the reaction with a crosslinker; whereas the acrylic polymer, when including the unit derived from the hydroxy-containing monomer in a content of 50 weight percent or less, tends to allow the pressure-sensitive adhesive layer to have more easily adjustable water absorbency.

Non-limiting examples of the sulfonic- or phosphoric-group-containing monomer include styrenesulfonic acid, allylsulfonic acid, sodium vinylsulfonate, 2-(meth)acrylamido-2-methylpropanesulfonic acid, (meth)acrylamidopropanesulfonic acid, sulfopropyl (meth)acrylate, (meth)acryloyloxynaphthalenesulfonic acid, and 2-hydroxyethylacryloyl phosphate.

Non-limiting examples of the epoxy-containing monomer include epoxy-containing (meth)acrylates such as glycidyl (meth)acrylate and 2-ethylglycidyl (meth)acrylate; allyl glycidyl ether; and glycidyl (meth)acrylate ether.

Non-limiting examples of the nitrogen-containing-group-containing monomer include cyano-containing monomers, isocyanato-containing monomers, amido-containing monomers, amino-containing monomers, and monomers each containing a nitrogen-containing ring. The acrylic polymer, when containing a unit derived from such a nitrogen-containing-group-containing monomer, tends to allow the optical pressure-sensitive adhesive composition to provide satisfactory bonding reliability.

Non-limiting examples of the cyano-containing monomers include acrylonitrile and methacrylonitrile.

A non-limiting example of the isocyanato-containing monomers is 2-isocyanatoethyl (meth)acrylate.

Non-limiting examples of the amido-containing monomers include (meth)acrylamide; N,N-dialkyl(meth)acrylamides, such as N,N-dimethyl(meth)acrylamide, N,N-diethyl(meth)acrylamide, N,N-dipropyl(meth)acrylamide, N,N-diisopropyl(meth)acrylamide, N,N-di(n-butyl)(meth)acrylamide, and N,N-di(t-butyl)(meth)acrylamide; N-alkyl(meth)acrylamides, such as N-ethyl(meth)acrylamide, N-isopropyl(meth)acrylamide, N-butyl(meth)acrylamide, and N-n-butyl(meth)acrylamide; N-vinylcarboxamides, such as N-vinylacetamide; monomers containing both hydroxy and amido, exemplified by N-hydroxyalkyl(meth)acrylamides, such as N-(2-hydroxyethyl)(meth)acrylamide, N-(2-hydroxypropyl)(meth)acrylamide, N-(1-hydroxypropyl)(meth)acrylamide, N-(3-hydroxypropyl)(meth)acrylamide, N-(2-hydroxybutyl)(meth)acrylamide, N-(3-hydroxybutyl)(meth)acrylamide, and N-(4-hydroxybutyl)(meth)acrylamide; monomers containing both alkoxy and amido, exemplified by N-alkoxyalkyl(meth)acrylamides, such as N-methoxymethyl(meth)acrylamide, N-methoxyethyl(meth)acrylamide, and N-butoxymethyl(meth)acrylamide; as well as N,N-dimethylaminopropyl(meth)acrylamide and N-(meth)acryloylmorpholine. In particular, (meth)acrylamide is preferred.

Non-limiting examples of the amino-containing monomers include aminoethyl (meth)acrylate, N,N-dimethylaminoethyl (meth)acrylate, and t-butylaminoethyl (meth)acrylate.

Non-limiting examples of the monomers each containing a nitrogen-containing ring include N-vinyl-2-pyrrolidone, N-methylvinylpyrrolidone, N-vinylpyridine, N-vinylpiperidone, N-vinylpyrimidine, N-vinylpiperazine, N-vinylpyrazine, N-vinylpyrrole, N-vinylimidazole, N-vinyloxazole, N-(meth)acryloyl-2-pyrrolidone, N-(meth)acryloylpiperidine, N-(meth)acryloylpyrrolidine, N-vinylmorpholine, N-vinyl-3-morpholinone, N-vinyl-2-caprolactam, N-vinyl-1,3-oxazin-2-one, N-vinyl-3,5-morpholinedione, N-vinylpyrazole, N-vinylisoxazole, N-vinylthiazole, N-vinylisothiazole, monomers having a succinimide skeleton (such as N-(meth)acryloyloxymethylenesuccinimide, N-(meth)acryloyl-6-oxyhexamethylenesuccinimide, and N-(meth)acryloyl-8-oxyoctamethylenesuccinimide), and itaconimides (such as N-methylitaconimide, N-ethylitaconimide, N-butylitaconimide, N-octylitaconimide, N-2-ethylhexylitaconimide, N-cyclohexylitaconimide, and N-laurylitaconimide). Among them, N-vinyl-2-pyrrolidone is preferred.

The content of a unit derived from the nitrogen-containing monomer in the acrylic polymer is preferably 40 weight percent or less, more preferably 35 weight percent or less, still more preferably 25 weight percent or less, and particularly preferably 20 weight percent or less, of the totality (100 weight percent) of all the monomer units. This is preferred for better bond strength. The lower limit of the content may be 0 weight percent, or may be 1 weight percent, 3 weight percent, 10 weight percent, or 15 weight percent.

The acrylic polymer may include a unit or units derived from each of different polar-group-containing monomers alone or in combination.

The acrylic polymer, when containing a unit derived from the alicyclic monomer, tends to allow the optical pressure-sensitive adhesive composition to provide easier removal of the pressure-sensitive adhesive layer while maintaining high cohesive force. Non-limiting examples of the alicyclic monomer include cycloalkyl (meth)acrylates having C₄-C₁₀ cycloalkyl, (meth)acrylic esters having a bicyclic hydrocarbon ring, and (meth)acrylic esters having a tricyclic or higher hydrocarbon ring. The cycloalkyl ring, the bicyclic hydrocarbon ring, and the tricyclic or higher hydrocarbon ring may each have one or more substituents. Non-limiting examples of the substituents include halogens (such as fluorine, chlorine, bromine, and iodine) and C₁-C₆ linear or branched chain alkyls (such as methyl, ethyl, n-propyl, and isopropyl). The rings may each have, for example, one to six substituents. When two or more substituents are present, they may be identical or different.

Non-limiting examples of the cycloalkyl (meth)acrylates include cyclopentyl (meth)acrylate, cyclohexyl (meth)acrylate, 3,3,5-trimethylcyclohexyl (meth)acrylate, cycloheptyl (meth)acrylate, and cyclooctyl (meth)acrylate. Among them, cyclohexyl acrylate and 3,3,5-trimethylcyclohexyl methacrylate are preferred.

Non-limiting examples of the (meth)acrylic esters having a bicyclic hydrocarbon ring include bornyl (meth)acrylate and isobornyl (meth)acrylate.

Non-limiting examples of the (meth)acrylic esters having a tricyclic or higher hydrocarbon ring include dicyclopentanyl (meth)acrylate, dicyclopentanyloxyethyl (meth)acrylate, tricyclopentanyl (meth)acrylate, 1-adamantyl (meth)acrylate, 2-methyl-2-adamantyl (meth)acrylate, and 2-ethyl-2-adamantyl (meth)acrylate.

The acrylic polymer may include a unit or units derived from each of different alicyclic monomers alone or in combination.

The content of such a unit derived from the alicyclic monomer in the acrylic polymer is preferably 40 weight percent or less, more preferably 30 weight percent or less, and still more preferably 25 weight percent or less, of the totality (100 weight percent) of all the monomer units. The lower limit of the content may be 0 weight percent, or may be 10 weight percent, or 15 weight percent. The acrylic polymer, when containing the unit derived from the alicyclic monomer in a content within the range, tends to allow the pressure-sensitive adhesive to have lower release force while having higher cohesive force.

The copolymerizable monomer(s) may include another monomer than the polar-group-containing monomers and the alicyclic monomers (the other monomer). Non-limiting examples of the other monomer include alkoxy-containing monomers, alkoxysilyl-containing monomers, vinyl esters, vinyl alkyl ethers, arene-containing monomers, and olefins or dienes.

Examples of the alkoxy-containing monomers include alkoxyalkyl (meth)acrylates and alkoxypolyalkylene glycol (meth)acrylates.

Non-limiting examples of the alkoxyalkyl (meth)acrylates include 2-methoxyethyl (meth)acrylate, 3-methoxypropyl (meth)acrylate, 2-ethyoxyethyl (meth)acrylate, propoxyethyl (meth)acrylate, butoxyethyl (meth)acrylate, and ethoxypropyl (meth)acrylate.

Non-limiting examples of the alkoxypolyalkylene glycol (meth)acrylates include methoxymethylene glycol (meth)acrylate, methoxypoly(ethylene glycol) (meth)acrylates, and methoxypoly(propylene glycol) (meth)acrylates.

Examples of the alkoxysilyl-containing monomers include alkoxysilyl-containing (meth)acrylates and alkoxysilyl-containing vinyl compounds.

Non-limiting examples of the alkoxysilyl-containing (meth)acrylates include 3-(meth)acryloxypropyltrimethoxysilane, 3-(meth)acryloxypropyltriethoxysilane, 3-(meth)acryloxypropylmethyldimethoxysilane, and 3-(meth)acryloxypropylmethyldiethoxysilane.

Non-limiting examples of the alkoxysilyl-containing vinyl compounds include vinyltrimethoxysilane and vinyltriethoxysilane.

The copolymerizable monomer(s) may include the alkoxy-containing monomer, but is preferably devoid of such alkoxy-containing monomers. The content of a unit derived from the alkoxy-containing monomer in the acrylic polymer may be less than 20 weight percent, or may be less than 10 weight percent, less than 3 weight percent, less than 1 weight percent, or less than 0.3 weight percent, of the totality (100 weight percent) of all the monomer units, from the viewpoint of easily forming the pressure-sensitive adhesive layer in the form of a sheet without problems such as gelation. The lower limit of the content is generally 0 weight percent.

Non-limiting examples of the vinyl esters include vinyl acetate and vinyl propionate.

Non-limiting examples of the vinyl alkyl ethers include methyl vinyl ether and ethyl vinyl ether.

Non-limiting examples of the arene-containing monomers include aromatic vinyl compounds and (meth)acrylic esters having an arene group (aromatic hydrocarbon group).

Non-limiting examples of the aromatic vinyl compounds include styrene, α-methylstyrene, and vinyltoluene.

Non-limiting examples of the arene-containing (meth)acrylic esters include phenyl (meth)acrylate, phenoxyethyl (meth)acrylate, and benzyl (meth)acrylate.

Non-limiting examples of the olefins or dienes include ethylene, butadiene, isoprene, and isobutylene.

In addition to these, examples of the other monomer also include heterocycle-containing (meth)acrylates such as tetrahydrofurfuryl (meth)acrylate; halogen-containing (meth)acrylates such as (meth)acrylates containing a vinyl chloride moiety or fluorine; and (meth)acrylic esters derived from terpene compound derivative alcohols.

The acrylic polymer may include a unit or units derived from each of different such other monomers alone or in combination.

The acrylic polymer may include a unit or units derived from the copolymerizable monomer in a content of preferably 1 weight percent or greater, more preferably 10 weight percent or greater, and still more preferably 15 weight percent or greater, of the totality (100 weight percent) of all the monomer units. The upper limit of the content of units derived from the copolymerizable monomer may typically be 55 weight percent, or may be 45 weight percent, or 38 weight percent. The acrylic polymer, when including the unit derived from the copolymerizable monomer in a content of 1 weight percent or greater, tends to more easily exhibit its utility; whereas, when including the unit derived from the copolymerizable monomer in a content of 55 weight percent or less, tends to more easily balance between adhesive strength and cohesive force.

The total content of units derived from the carboxy-containing monomer, acid anhydride-containing monomer, hydroxy-containing monomer, nitrogen-containing-group-containing monomer, and alkoxy-containing monomer in the acrylic polymer is preferably 55 weight percent or less, more preferably 50 weight percent or less, still more preferably 45 weight percent or less, particularly preferably 40 weight percent or less, and most preferably 38 weight percent or less, of the totality (100 weight percent) of all the monomer units. The lower limit of the total content may typically be 1 weight percent, or may be 10 weight percent or 15 weight percent. The acrylic polymer, when having a total content as above of 55 weight percent or less, less causes metal corrosion; and, when having a total content of 1 weight percent or greater, tends to give lower release force upon separation and recovery.

The acrylic polymer may include unpolymerized monomers (such as the (meth)acrylic alkyl esters and the copolymerizable monomers), and/or oligomers of these monomers.

The acrylic polymer has a weight-average molecular weight (Mw) of preferably 10 ×10⁴ or greater, more preferably 20 ×10⁴ or greater, still more preferably 30 ×10⁴ or greater, particularly preferably 40 ×10⁴ or greater, still particularly preferably 50 ×10⁴ or greater, and most preferably 55 ×10⁴ or greater. The upper limit of the weight-average molecular weight is generally 500 ×10⁴, and may be 150 ×10⁴, or 75 ×10⁴. The acrylic polymer, when having a weight-average molecular weight (Mw) of 10 ×10⁴ or greater, tends to provide adhesive strength, cohesive force, and storage modulus in good balance; and, when having a weight-average molecular weight (Mw) of 500 ×10⁴ or less, tends to provide satisfactory bonding reliability even in a high-temperature environment. The weight-average molecular weight (Mw) can be determined by gel permeation chromatography (GPC) measurement and calibration with a polystyrene standard.

The optical pressure-sensitive adhesive composition may include, in addition to the acrylic polymer, any of other components or additives within ranges not adversely affecting the advantageous effects of the present invention. Non-limiting examples of such additives include polymerization initiators, crosslinkers, multifunctional monomers, silane coupling agents, solvents, tackifier resins (such as rosin derivatives, polyterpene resins, petroleum resins, and oil-soluble phenols), age inhibitors, fillers, ultraviolet absorbers, antioxidants, chain-transfer agents, plasticizers, softeners, surfactants, antistatic agents, and rust inhibitors. The optical pressure-sensitive adhesive composition may include each of different additives alone or in combination.

The optical pressure-sensitive adhesive composition may include such additives in a total content of preferably 10 weight percent or less, more preferably 5 weight percent or less, still more preferably 3 weight percent or less, and particularly preferably 1 weight percent or less, from the viewpoint of providing sufficient transparency of the pressure-sensitive adhesive layer made from the composition.

Examples of the polymerization initiators include photo-polymerization initiators (photoinitiators) and thermal initiators. The optical pressure-sensitive adhesive composition may include each of different polymerization initiators alone or in combination. The optical pressure-sensitive adhesive composition does not necessarily have to include such a polymerization initiator, because the pressure-sensitive adhesive layer made from the optical pressure-sensitive adhesive composition has sufficient shape stability.

Examples of the photoinitiator include, but are not limited to, benzoin ether photoinitiators, acetophenone photoinitiators, α-ketol photoinitiators, aromatic sulfonyl chloride photoinitiators, photoactive oxime photoinitiators, benzoin photoinitiators, benzil photoinitiators, benzophenone photoinitiators, ketal photoinitiators, and thioxanthone photoinitiators.

Non-limiting examples of the benzoin ether photoinitiators include benzoin methyl ether, benzoin ethyl ether, benzoin propyl ether, benzoin isopropyl ether, benzoin isobutyl ether, 2,2-dimethoxy-1,2-diphenylethan-1-one, and anisoin methyl ether.

Non-limiting examples of the acetophenone photoinitiators include 2,2-diethoxyacetophenone, 2,2-dimethoxy-2-phenylacetophenone, 1-hydroxycyclohexylphenyl ketone, 4-phenoxydichloroacetophenone, and 4-(t-butyl)dichloroacetophenone.

Non-limiting examples of the α-ketol photoinitiators include 2-methyl-2-hydroxypropiophenone and 1-[4-(2-hydroxyethyl)phenyl]-2-methylpropan-1-one.

A non-limiting example of the aromatic sulfonyl chloride photoinitiators is 2-naphthalenesulfonyl chloride.

A non-limiting example of the photoactive oxime photoinitiators is 1-phenyl-1,2-propanedione-2-(O-ethoxycarbonyl)-oxime.

A non-limiting example of the benzoin photoinitiators is benzoin.

A non-limiting example of the benzil photoinitiators is benzil.

Non-limiting examples of the benzophenone photoinitiators include benzophenone, benzoylbenzoic acid, 3,3'-dimethyl-4-methoxybenzophenone, polyvinylbenzophenones, and α-hydroxycyclohexyl phenyl ketone.

A non-limiting example of the ketal photoinitiators is benzil dimethyl ketal.

Non-limiting examples of the thioxanthone photoinitiators include thioxanthone, 2-chlorothioxanthone, 2-methylthioxanthone, 2,4-dimethylthioxanthone, isopropylthioxanthone, 2,4-diisopropylthioxanthone, and dodecylthioxanthone.

The photoinitiator, when used, is present in an amount of preferably 0.01 to 1 part by weight, and more preferably 0.05 to 0.5 part by weight, per 100 parts by weight of the acrylic polymer, although the photoinitiator may be present in any other amount.

Examples of the thermal initiators include azo polymerization initiators, peroxide polymerization initiators (such as dibenzoyl peroxide and tert-butyl permaleate), and redox polymerization initiators. Among them, azo polymerization initiators are preferred.

Non-limiting examples of the azo polymerization initiators include 2,2'-azobisisobutyronitrile, 2,2'-azobis-2-methylbutyronitrile, dimethyl 2,2'-azobis(2-methylpropionate), and 4,4'-azobis-4-cyanovaleric acid.

Such an azo polymerization initiator may be used in an amount of preferably 0.05 to 0.5 part by weight, and more preferably 0.1 to 0.3 part by weight, per 100 parts by weight of the acrylic polymer, although the azo polymerization initiator may be used in any other amount.

The optical pressure-sensitive adhesive composition may contain the crosslinker(s) for the purpose of crosslinking in the pressure-sensitive adhesive layer, or crosslinking between the pressure-sensitive adhesive layer and the surface of an adjacent layer. Specific examples of the crosslinkers include isocyanate crosslinkers, epoxy crosslinkers, oxazoline crosslinkers, aziridine crosslinkers, carbodiimide crosslinkers, melamine crosslinkers, urea crosslinkers, metal alkoxide crosslinkers, metal chelate crosslinkers, metal salt crosslinkers, hydrazine crosslinkers, and amine crosslinkers. The optical pressure-sensitive adhesive composition may contain each of different crosslinkers alone or in combination.

The isocyanate crosslinkers are preferably compounds each having two or more isocyanate groups per molecule; and specific examples thereof include aromatic isocyanates (such as tolylene diisocyanate, xylene diisocyanate, polymethylenepolyphenyl diisocyanate, tris(p-isocyanatophenyl) thiophosphate, and diphenylmethane diisocyanate), alicyclic isocyanates (such as isophorone diisocyanate), and aliphatic isocyanates (such as hexamethylene diisocyanate).

The epoxy crosslinkers are preferably compounds each having two or more (preferably three to five) epoxy groups per molecule; and specific examples thereof include N,N,N',N'-tetraglycidyl-m-xylenediamine, 1,3-bis(N,N-diglycidylaminomethyl)cyclohexane, 1,6-hexanediol diglycidyl ether, polyethylene glycol diglycidyl ethers, and polyglycerol polyglycidyl ethers.

The oxazoline crosslinkers are preferably compounds each having one or more oxazoline groups per molecule.

Non-limiting examples of the aziridine crosslinkers include trimethylolpropane tris[3-(1-aziridinyl)propionate] and trimethylolpropane tris[3-(1-(2-methyl)aziridinylpropionate)].

The carbodiimide crosslinkers are preferably low-molecular compounds or polymeric compounds each having two or more carbodiimide groups.

The optical pressure-sensitive adhesive composition may contain the crosslinker(s) in a content of preferably 5 parts by weight or less, more preferably 0.001 to 5 parts by weight, still more preferably 0.005 to 3 parts by weight, and particularly preferably 0.01 to 1 part by weight, per 100 parts by weight of the acrylic polymer, for actually providing adhesive strength, cohesive force, and storage modulus in good balance.

The optical pressure-sensitive adhesive composition may contain the multifunctional monomer(s) instead of or in combination with the crosslinker(s), so as to adjust the cohesive force. Specific, but non-limiting examples of such multifunctional monomers include ethylene glycol di(meth)acrylate, propylene glycol di(meth)acrylate, polyethylene glycol di(meth)acrylates, polypropylene glycol di(meth)acrylates, neopentyl glycol di(meth)acrylate, pentaerythritol di(meth)acrylate, pentaerythritol tri(meth)acrylate, dipentaerythritol hexa(meth)acrylate, ethylene glycol di(meth)acrylate, 1,6-hexanediol di(meth)acrylate, 1,12-dodecanediol di(meth)acrylate, trimethylolpropane tri(meth)acrylate, tetramethylolmethane tri(meth)acrylate, allyl (meth)acrylate, vinyl (meth)acrylate, divinylbenzene, epoxy acrylates, polyester acrylates, urethane acrylates, butyldiol di(meth)acrylate, and hexyldiol di(meth)acrylate. The optical pressure-sensitive adhesive composition may contain each of different multifunctional monomers alone or in combination.

The content of the multifunctional monomer(s) in the optical pressure-sensitive adhesive composition is preferably 5 parts by weight or less, more preferably 3 parts by weight or less, and still more preferably 1 part by weight or less, per 100 parts by weight of the acrylic polymer. The lower limit of the content may be 0 part by weight, or may be 0.001 part by weight, 0.005 part by weight, 0.007 part by weight, or 0.01 part by weight. The optical pressure-sensitive adhesive composition, when containing the multifunctional monomer in a content within the range, tends to avoid or minimize lowering in bond strength between the pressure-sensitive adhesive layer and an adjacent layer, where the lowering in bond strength will be caused by excessively high cohesive force.

Non-limiting examples of the silane coupling agents include γ-glycidoxypropyltrimethoxysilane, γ-glycidoxypropyltriethoxysilane, γ-aminopropyltrimethoxysilane, and N-phenyl-aminopropyltrimethoxysilane. In particular, γ-glycidoxypropyltrimethoxysilane is preferred. The optical pressure-sensitive adhesive composition may contain each of different silane coupling agents alone or in combination.

The content of the silane coupling agent(s) in the optical pressure-sensitive adhesive composition is preferably 1.0 part by weight or less, and more preferably 0.5 part by weight or less, per 100 parts by weight of the acrylic polymer. The range is preferred from the viewpoint of minimizing adhesive residue upon separation and recovery while maintaining bonding reliability of the pressure-sensitive adhesive layer to the glass during use of the image display device. The lower limit of the content may be 0 part by weight, or may be 0.01 part by weight or 0.03 part by weight.

The solvents are exemplified by, but not limited to, organic solvents including esters (such as ethyl acetate and n-butyl acetate), aromatic hydrocarbons (arenes) (such as toluene and benzene), aliphatic hydrocarbons (such as n-hexane and n-heptane), alicyclic hydrocarbons (such as cyclohexane and methylcyclohexane), and ketones (such as methyl ethyl ketone and methyl isobutyl ketone). The optical pressure-sensitive adhesive composition may contain each of different solvents alone or in combination.

The optical pressure-sensitive adhesive composition may be in any form (type) and may typically be in an emulsion form, a solvent-borne form (solution form), or a thermofusible form (hot-melt form). In particular, the optical pressure-sensitive adhesive composition is preferably in a solvent-borne form.

For example, assume that the optical pressure-sensitive adhesive composition is a solvent-borne pressure-sensitive adhesive composition. In this case, the optical pressure-sensitive adhesive composition can be prepared typically by mixing and polymerizing monomers to constitute the acrylic polymer, any additive or additives, and any solvent or solvents according to a known or common technique.

### Pressure-Sensitive Adhesive Layer

The pressure-sensitive adhesive layer of the present invention is formed from or made from the optical pressure-sensitive adhesive composition and is used for lamination between adherends, such as an organic electroluminescent display panel and a transparent component (such as cover glass) to be disposed on the side from which the image display panel is seen.

The pressure-sensitive adhesive layer maintains satisfactory bond strength during use of the image display device. In addition, because of having the release force X as above, the pressure-sensitive adhesive layer exhibits such excellent heating reworkability as to be easily removed from the component such as cover glass while utilizing flexible bending of the flexible organic electroluminescent display panel, upon separation and recovery of the component such as cover glass.

The pressure-sensitive adhesive layer may be formed by applying the optical pressure-sensitive adhesive composition typically to an organic electroluminescent display panel and, as needed, heat drying and/or curing the applied layer. The adhesive face of the formed pressure-sensitive adhesive layer may be protected by a release film before lamination with the component such as cover glass. The release film will be removed upon application to the adherend.

The application (coating) of the composition to the organic electroluminescent display panel can be performed by a known or common coating technique typically using any of coaters (such as rotogravure roll coaters, reverse roll coaters, kiss-contact roll coaters, dip roll coaters, bar coaters, knife coaters, spray coaters, comma coaters, and direct coaters) .

The pressure-sensitive adhesive layer may also be formed by applying a pressure-sensitive adhesive sheet to an organic electroluminescent display panel. The pressure-sensitive adhesive sheet is formed by applying the optical pressure-sensitive adhesive composition to a release film by a coating technique similar to those described above, and, as needed, heat drying and/or curing the applied composition.

The pressure-sensitive adhesive sheet may be one whose adhesive faces are protected with two film substrates (e.g., two release films), in which the adhesive face of the pressure-sensitive adhesive layer formed on the release film is protected with another release film. Alternatively, the pressure-sensitive adhesive sheet may be a rolled one in which the pressure-sensitive adhesive layer is formed on a release film having release surfaces on both sides, and wound into a roll so that the release film protects both the two adhesive faces of the pressure-sensitive adhesive layer.

Non-limiting examples of the release film include bases having a release layer (release-treated layer); low-adhesive bases made of fluorocarbon polymers; and low-adhesive bases made of nonpolar polymers. Non-limiting examples of the bases having a release layer include plastic films and paper whose surface has been treated with a release agent. Non-limiting examples of the release agent include silicones, long-chain alkyls, fluorocarbons, and molybdenum sulfide. Non-limiting examples of the fluorocarbon polymers constituting the low-adhesive bases include polytetrafluoroethylenes, polychlorotrifluoroethylenes, poly(vinyl fluoride)s, poly(vinylidene fluoride)s, tetrafluoroethylene-hexafluoropropylene copolymers, and chlorofluoroethylene-vinylidene fluoride copolymers. Non-limiting examples of the nonpolar polymers include olefinic resins (such as polyethylenes and polypropylenes). The release film is formed by a known or common technique. The conditions or parameters, such as thickness, of the release film are also not limited.

The pressure-sensitive adhesive layer has a thickness of typically preferably 10 to 1000 µm. The lower limit of the thickness may be 20 µm, or may be 30 µm, 40 µm, or 50 µm. The upper limit of the thickness may be 900 µm, or may be 800 µm, 700 µm, or 500 µm. The pressure-sensitive adhesive layer, when having a thickness of 10 µm or greater, exhibits better bump absorptivity (conformability to bumps) and tends to have better heating reworkability, because the pressure-sensitive adhesive layer less suffers from damage upon separation and recovery. The pressure-sensitive adhesive layer, when having a thickness of 1000 µm or less, tends to have better heating reworkability, because the pressure-sensitive adhesive layer can bend together with the organic electroluminescent display panel and is easily removed from the component such as cover glass upon separation and recovery.

The pressure-sensitive adhesive layer has excellent bond strength in use and may also be used for the lamination of another image display panel (such as a liquid crystal display panel or plasma display panel) than the organic electroluminescent display panel, with a transparent component (such as cover glass).

The pressure-sensitive adhesive layer may also be used for the lamination of a transparent component (such as cover glass) with an adherend film substrate disposed on the side from which such an image display panel is seen. Non-limiting examples of the film substrate include optical films (such as antireflection films, polarizing plates, and retardation films), and film sensors.

The pressure-sensitive adhesive layer may also be applied to a film substrate (plastic film) as an adherend to form a surface-protecting film. The surface-protecting film is useful for surface protection of an optical element (such as an image display panel), because the pressure-sensitive adhesive layer has satisfactory conformability.

Non-limiting examples of the plastic material constituting the plastic film include polyester resins (such as poly(ethylene terephthalate)s), acrylic resins (such as poly(methyl methacrylate)s), polycarbonates, triacetyl cellulose (TAC), polysulfones, polyarylates, polyimides, poly(vinyl chloride)s, poly(vinyl acetate)s, polyethylenes, polypropylenes, ethylene-propylene copolymers, and cycloolefin polymers. The plastic film may be made from each of different plastic materials alone or in combination. Examples

The present invention will be illustrated in further detail with reference to several examples below. It should be noted, however, that the examples are by no means intended to limit the scope of the present invention.

### Preparation of Pressure-Sensitive Adhesive Compositions

### Pressure-Sensitive Adhesive Composition A

Into a four-necked flask, were charged a monomer mixture including 10 parts by weight of 2-ethylhexyl acrylate (2EHA), 35 parts by weight of n-butyl acrylate (BA), 20 parts by weight of cyclohexyl acrylate (CHA), and 35 parts by weight of 4-hydroxybutyl acrylate (4HBA); 0.09 part by weight of 2,2-dimethoxy-1,2-diphenylethane-1-one (trade name Irgacure 651, BASF Japan Ltd.); and 0.09 part by weight of 1-hydroxy-cyclohexyl phenyl ketone (trade name Irgacure 184, BASF Japan Ltd.). The resulting mixture was exposed to ultraviolet radiation in a nitrogen atmosphere to be partially photopolymerized, and yielded a partial polymer having a degree of polymerization of about 10%. The partial polymer (100 parts by weight) combined with and uniformly mixed with 0.14 part by weight of a multifunctional monomer (dipentaerythritol hexaacrylate, trade name KAYARAD DPHA, Nippon Kayaku Co., Ltd.) and 0.3 part by weight of a silane coupling agent (3-glycidoxypropyltrimethoxysilane, trade name KBM-403, Shin-Etsu Chemical Co., Ltd.), and yielded a pressure-sensitive adhesive composition A.

### Pressure-Sensitive Adhesive Composition B

Into a four-necked flask, were charged a monomer mixture including 60 parts by weight of n-butyl acrylate (BA), 20 parts by weight of 4-hydroxybutyl acrylate (4HBA), and 20 parts by weight of N-vinyl-2-pyrrolidone (NVP); 0.09 part by weight of 2,2-dimethoxy-1,2-diphenylethane-1-one (trade name Irgacure 651, BASF Japan Ltd.); and 0.09 part by weight of 1-hydroxy-cyclohexyl phenyl ketone (trade name Irgacure 184, BASF Japan Ltd.). The resulting mixture was exposed to ultraviolet radiation in a nitrogen atmosphere to be partially photopolymerized, and yielded a partial polymer having a degree of polymerization of about 10%. The partial polymer (100 parts by weight) combined with and uniformly mixed with 0.2 part by weight of a multifunctional monomer (dipentaerythritol hexaacrylate, trade name KAYARAD DPHA, Nippon Kayaku Co., Ltd.), and 0.3 part by weight of a silane coupling agent (3-glycidoxypropyltrimethoxysilane, trade name KBM-403, Shin-Etsu Chemical Co., Ltd.), and yielded a pressure-sensitive adhesive composition B.

### Pressure-Sensitive Adhesive Composition C

Into a four-necked flask, were charged a monomer mixture including 50 parts by weight of n-butyl acrylate (BA), 40 parts by weight of isostearyl acrylate (ISA), and 10 parts by weight of N-vinyl-2-pyrrolidone (NVP); 0.09 part by weight of 2,2-dimethoxy-1,2-diphenylethane-1-one (trade name Irgacure 651, BASF Japan Ltd.), and 0.09 part by weight of 1-hydroxy-cyclohexyl phenyl ketone (trade name Irgacure 184, BASF Japan Ltd.). The resulting mixture was exposed to ultraviolet radiation in a nitrogen atmosphere to be partially photopolymerized, and yielded a partial polymer having a degree of polymerization of about 10%. The partial polymer (100 parts by weight) combined with and uniformly mixed with 0.02 part by weight of a multifunctional monomer (dipentaerythritol hexaacrylate, trade name KAYARAD DPHA, Nippon Kayaku Co., Ltd.), and yielded a pressure-sensitive adhesive composition C.

### Pressure-Sensitive Adhesive Composition D

A pressure-sensitive adhesive composition D was prepared by a procedure similar to that in the pressure-sensitive adhesive composition B, except for using the multifunctional monomer (dipentaerythritol hexaacrylate, trade name KAYARAD DPHA, Nippon Kayaku Co., Ltd.) in an amount of 0.01 part by weight, and giving a degree of polymerization of about 10%.

### Pressure-Sensitive Adhesive Composition E

Into a four-necked flask, were charged a monomer mixture including 47 parts by weight of 2-ethylhexyl acrylate (2EHA), 45 parts by weight of isostearyl acrylate (ISA), 3 parts by weight of 4-hydroxybutyl acrylate (4HBA), and 5 parts by weight of N-vinyl-2-pyrrolidone (NVP); 0.09 part by weight of 2,2-dimethoxy-1,2-diphenylethane-1-one (trade name Irgacure 651, BASF Japan Ltd.); and 0.09 part by weight of 1-hydroxy-cyclohexyl-phenyl- ketone (trade name Irgacure 184, BASF Japan Ltd.). The resulting mixture was exposed to ultraviolet radiation in a nitrogen atmosphere to be partially photopolymerized, and yielded a partial polymer having a degree of polymerization of about 10%. The partial polymer (100 parts by weight) combined with and uniformly mixed with 0.02 part by weight of a multifunctional monomer (dipentaerythritol hexaacrylate, trade name KAYARAD DPHA, Nippon Kayaku Co., Ltd.) and 0.3 part by weight of a silane coupling agent (3-glycidoxypropyltrimethoxysilane, trade name KBM-403, Shin-Etsu Chemical Co., Ltd.), and yielded a pressure-sensitive adhesive composition E.

### Pressure-Sensitive Adhesive Composition F

A pressure-sensitive adhesive composition F was prepared by a procedure similar to that in the pressure-sensitive adhesive composition E, except for using the multifunctional monomer (dipentaerythritol hexaacrylate, trade name KAYARAD DPHA, Nippon Kayaku Co., Ltd.) in an amount of 0.10 part by weight, and giving a degree of polymerization of about 10%.

### [Table 1]

**TABLE 1**

| Pressure-sensitive adhesive composition | Monomer component (part by weight) | | | | | | Additive (part by weight) | |
|---|---|---|---|---|---|---|---|---|
| | 2EHA | BA | ISA | CHA | 4HBA | NVP | Multifunctional monomer | Silane coupling agent |
| A | 10 | 35 | 0 | 20 | 35 | 0 | 0.14 | 0.3 |
| B | 0 | 60 | 0 | 0 | 20 | 20 | 0.20 | 0.3 |
| C | 0 | 50 | 40 | 0 | 10 | 0 | 0.02 | 0 |
| D | 0 | 60 | 0 | 0 | 20 | 20 | 0.01 | 0.3 |
| E | 47 | 0 | 45 | 0 | 3 | 5 | 0.02 | 0.3 |
| F | 47 | 0 | 45 | 0 | 3 | 5 | 0.10 | 0.3 |

### Examples 1 to 8 and Comparative Example 1

Each of the pressure-sensitive adhesive compositions A to F was applied to the release surface of a release film (a poly(ethylene terephthalate) film one of whose surfaces had been release-treated), having a thickness of 38 µm, trade name MRF38, Mitsubishi Plastics, Inc. (now Mitsubishi Chemical Corporation)) to form a coating layer, and another ply of the release film was placed on the coating layer. Then the resulting article was irradiated with ultraviolet radiation at an intensity of 6.5 mW/cm² to a cumulative irradiance of 1500 mJ/cm² using a black light lamp and yielded a pressure-sensitive adhesive sheet including a pressure-sensitive adhesive layer, and the release films disposed on both sides of the layer. The pressure-sensitive adhesive layer had a thickness as given in Table 2.

Properties were evaluated or measured by the following methods.

### Release Force X Measurement

The above-obtained pressure-sensitive adhesive sheet was cut into a 50-mm wide, 100-mm long piece, from which one release film was removed, and the resulting piece was applied to an adherend glass (soda lime glass plate with polished edge, OF1, Matsunami Glass Ind., Ltd.) using a 2-kg roller, and yielded an evaluation sample. The evaluation sample was stored at an ambient temperature of 23°C and relative humidity of 50% for 30 minutes, underwent measurement of tensile strength at an ambient temperature of 100°C, a peel angle of 180 degrees, and a tensile speed of 50 mm/min using a tensile tester (Autograph, Shimadzu Corporation), and the release force (N/20 mm) was determined from the measured tensile strength. The results are given in Table 2.

### Release Force Y Measurement

The release force Y was measured by a procedure similar to that in the release force X, except for performing the measurement at an ambient temperature of 25°C and relative humidity of 50%. The results are given in Table 2.

### Storage Modulus Measurement

The release films were removed from the above-obtained pressure-sensitive adhesive sheet to give a pressure-sensitive adhesive layer alone, and plies of the pressure-sensitive adhesive layer stacked to give a pressure-sensitive adhesive layer sample having a thickness of about 1.5 mm. The pressure-sensitive adhesive layer sample underwent storage modulus measurement at a temperature of 25°C or 100°C using parallel plates (8.0 mm in diameter), in torsional mode, in the frequency range of 1 Hz using a dynamic viscoelastometer (Advanced Rheometric Expansion System (ARES), Rheometric Scientific). The results are given in Table 2.

### Moisture Content Measurement

The above-obtained pressure-sensitive adhesive sheet was cut to a 1-cm square piece, from which the release films were removed, and the residual pressure-sensitive adhesive layer was applied to aluminum foil to give an evaluation sample. The evaluation sample stood at an ambient temperature of 95°C and relative humidity of 0% until the weight change ceased, to completely remove moisture therefrom. The weight (W1) of the evaluation sample in this state was measured. Next, the evaluation sample was stored at an ambient temperature of 23°C and relative humidity of 50% for 24 hours, and the weight (W2) of the sample was measured. The moisture content of the sample was determined according to the following equation. The results are given in Table 2.

### Moisture content (weight percent) = ((W1 - W2)/W1) × 100

### Measurement of Variation in Chromaticity b*

The above-obtained pressure-sensitive adhesive sheet was cut to a 5-cm square piece, from which the release films were removed to give a pressure-sensitive adhesive layer. Glass plates were laminated on both sides of the pressure-sensitive adhesive layer and yielded an evaluation sample. The evaluation sample was stored at 100°C for 1000 hours, and the chromaticity b* of the pressure-sensitive adhesive layer was measured before and after storage using a spectrophotometer (U-4100, Hitachi High-Tech Corporation) using a D65 light source, at an irradiation angle of 2°. The variation in chromaticity b* was determined by subtracting the chromaticity b* before storage from the chromaticity b* after storage. The results are given in Table 2.

### Heating Reworkability Evaluation

The above-obtained pressure-sensitive adhesive sheet was cut into a 50-mm wide, 100-mm long piece, from which one release film was removed, and the resulting piece was applied to an adherend glass (soda lime glass plate with polished edge, OF1, Matsunami Glass Ind., Ltd.) using a 2-kg roller, and yielded an evaluation sample. The evaluation sample was stored at an ambient temperature of 23°C and relative humidity of 50% for 30 minutes, the pressure-sensitive adhesive layer was then removed from the glass at an ambient temperature of 100°C, a peel angle of 180 degrees, and a tensile speed of 50 mm/min using a tensile tester (Autograph, Shimadzu Corporation), and whether an adhesive residue remained on the release surface of the glass was visually observed. The heating reworkability was evaluated according to the following criteria. The results are given in Table 2.

| | |
|---|---|
| Good (G) | No adhesive residue remained; |
| Fair (F) | Adhesive residue remained partially; and |
| Poor (P) | Adhesive residue remained entirely. |

### [Table 2]

**TABLE 2**

| | | Pressure-sensitive adhesive composition | Thickness of pressure-sensitive adhesive layer (µm) | Release force (N/20 mm) | | Ratio between release force | Storage modulus (×10⁵ Pa) | | Moisture content (wt.%) | Variation in b* | b* | | Heating reworkability |
|---|---|---|---|---|---|---|---|---|---|---|---|---|---|
| | | | | X | Y | (Y/X) | 100°C | 25°C | | | Initial | After storage | |
| Example | 1 | A | 250 | 2.0 | 8.0 | 4.0 | 0.9 | 1.6 | 1.1 | 0.1 | 0.5 | 0.6 | Good |
| | 2 | A | 500 | 3.0 | 11.0 | 3.7 | 0.9 | 1.6 | 1.1 | 0.1 | 0.5 | 0.6 | Good |
| | 3 | A | 100 | 1.8 | 5.6 | 3.1 | 0.9 | 1.6 | 1.1 | 0.1 | 0.5 | 0.6 | Good |
| | 4 | A | 50 | 1.6 | 4.0 | 2.5 | 0.9 | 1.6 | 1.1 | 0.1 | 0.5 | 0.6 | Good |
| | 5 | B | 250 | 3.2 | 16.0 | 5.0 | 1.1 | 1.7 | 1.0 | 0.6 | 0.6 | 1.2 | Good |
| | 6 | C | 250 | 1.0 | 14.0 | 14.0 | 0.4 | 1.5 | 0.8 | 0.3 | 0.5 | 0.8 | Fair |
| | 7 | D | 250 | 1.8 | 12.0 | 6.7 | 0.1 | 1.6 | 1.0 | 0.3 | 0.5 | 0.8 | Fair |
| | 8 | E | 250 | 3.2 | 14.0 | 4.4 | 0.4 | 1.6 | 0.6 | 0.5 | 0.5 | 1.0 | Fair |
| Comparative Example | 1 | F | 250 | 5.6 | 16.0 | 2.9 | 0.8 | 1.6 | 0.6 | 0.9 | 0.6 | 1.5 | Poor |

The pressure-sensitive adhesive layers of Examples 1 to 8 had a release force X of 1.0 to 3.2 N/20 mm, within the range of 4.0/20 mm or less, and had satisfactory, good or fair, results in heating reworkability.

In contrast, the pressure-sensitive adhesive layer of Comparative Example 1 had a release force X of 5.6 N/20 mm and exhibited a poor result in heating reworkability (evaluated as having poor heating reworkability).

### Reference Signs List

- 10: image display device
- 1: cover glass
- 2: pressure-sensitive adhesive layer
- 3: organic electroluminescent display panel
- 11: image display device upon separation and recovery

## Claims

1. An optical pressure-sensitive adhesive composition that gives a release force X of 4.0 N/20 mm or less,
where the release force X is a release force determined by applying a film to a glass plate through a pressure-sensitive adhesive layer made from the optical pressure-sensitive adhesive composition, and pulling the film at a temperature of 100°C, a peel angle of 180 degrees, and a tensile speed of 50 mm/min.

2. The optical pressure-sensitive adhesive composition according to claim 1,
wherein the pressure-sensitive adhesive composition gives a ratio (Y/X) of a release force Y to the release force X of 15.0 or less,
where the release force Y is a release force determined by applying a film to a glass plate through a pressure-sensitive adhesive layer made from the optical pressure-sensitive adhesive composition, and pulling the film at a temperature of 25°C, a peel angle of 180 degrees, and a tensile speed of 50 mm/min.

3. The optical pressure-sensitive adhesive composition according to one of claims 1 and 2,
wherein the optical pressure-sensitive adhesive composition has a storage modulus at 100°C of 0.1 ×10⁵ Pa or greater.

4. The optical pressure-sensitive adhesive composition according to any one of claims 1 to 3,
wherein the optical pressure-sensitive adhesive composition has a moisture content of 0.6 to 5.0 weight percent when stored at a temperature of 23°C and relative humidity of 50% for 24 hours.

5. The optical pressure-sensitive adhesive composition according to any one of claims 1 to 4,
wherein the pressure-sensitive adhesive composition gives a variation in chromaticity b* of 1.0 or less, where the variation is a variation in chromaticity b* of a pressure-sensitive adhesive layer made from the optical pressure-sensitive adhesive composition and is determined when the pressure-sensitive adhesive layer is placed between a pair of glass plates and is then stored at 100°C for 1000 hours.

6. A pressure-sensitive adhesive layer made from the optical pressure-sensitive adhesive composition according to any one of claims 1 to 5.

7. The pressure-sensitive adhesive layer according to claim 6,
wherein the pressure-sensitive adhesive layer is to be applied to at least one of a film substrate and an organic electroluminescent display panel as an adherend.
